Europäisches Patentamt

European Patent Office

Office européen des brevets

(19)

(11) Publication number: **0 180 781**
B1

(12)

# EUROPEAN PATENT SPECIFICATION

(45) Date of publication of the patent specification:
25.04.90

(51) Int. Cl.⁴: **H01L 31/18,** H01L 31/02,
H01L 31/06

(21) Application number: **85112617.7**

(22) Date of filing: **04.10.85**

(54) Process for producing amorphous silicon solar cells and product produced thereby.

(30) Priority: **05.10.84 JP 209213/84**

(43) Date of publication of application:
**14.05.86 Bulletin 86/20**

(45) Publication of the grant of the patent:
**25.04.90 Bulletin 90/17**

(84) Designated Contracting States:
**DE FR GB**

(56) References cited:
**GB-A- 2 135 510
US-A- 4 028 720
US-A- 4 379 943
US-A- 4 396 793**

**SOLAR CELLS, vol. 6, no. 1, June 1982, pages 49-58,
Amsterdam, NL; R.D. NASBY et al.: "High efficiency
p+-n-n+ silicon concentrator solar cells"
JAPANESE JOURNAL OF APPLIED PHYSICS,
supplements (1983), suppl. 15th conf., pages 189-192,
Tokyo, JP; K. OKUDA et al.: "a-Si Solar cells having
more than 9% conversion efficiency"**

(73) Proprietor: **FUJI ELECTRIC CORPORATE RESEARCH
AND DEVELOPMENT LTD., 2-1, Nagasaka 2-chome,
Yokosuka-shi Kanagawa-ken(JP)**

(72) Inventor: **Uchida, Yoshiyuki Fuji Electric Corporate
Research, Development Ltd. No. 2-1,
Nagasaka 2-chome, Yokosuka-shi Kanagawa(JP)**
Inventor: **Nabeta, Osamu Fuji Electric Corporate
Research, Development Ltd. No. 2-1,
Nagasaka 2-chome, Yokosuka-shi Kanagawa(JP)**
Inventor: **Kamiyama, Michinari Fuji Electric Corporate
Res., Development Ltd. No. 2-1, Nagasaka 2-chome,
Yokosuka-shi Kanagawa(JP)**

(74) Representative: **Patentanwälte Grünecker, Kinkeldey,
Stockmair & Partner, Maximilianstrasse 58,
D-8000 München 22(DE)**

# Description

## FIELD OF THE INVENTION

The present invention relates to a product and process for producing an amorphous silicon (a-Si) solar cell having a p- i-n structure of a-Si that is formed by a film deposition technique using the glow discharge decomposition process.

## BACKGROUND OF THE INVENTION

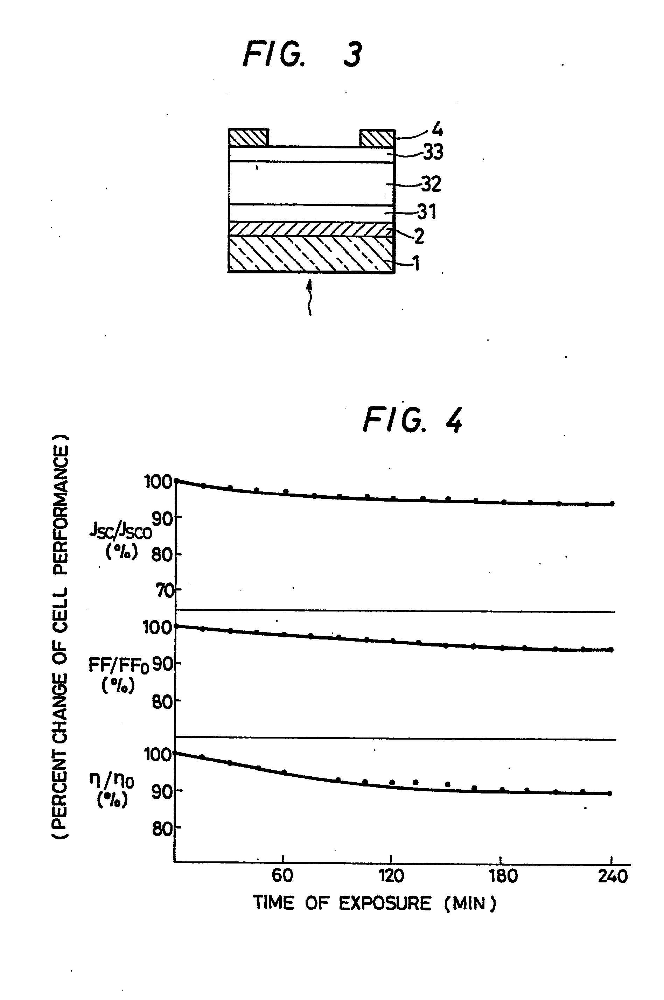

Amorphous silicon solar cells having large effective areas can be easily produced at low cost by using the technique of glow discharge decomposition, and active efforts are being made with a view to incorporating such a-Si solar cells as one of the core elements of the large-scale power generating systems projected for future energy needs. Solar cells of this type generally use a glass or stainless steel substrate, and produce a p-i-n structure on this substrate, by successive deposition of p, i and n layers of an a-Si film. The junction structure of a typical a-Si solar cell using a glass substrate is shown in Figure 3. As shown, this cell has a glass substrate 1 that has formed thereon a transparent electrode 2 of tin oxide ($SnO_2$), indium tin oxide (ITO), which is successively deposited with a p layer 31 in a thickness of 50-500 Å, an i layer 32 in a thickness of 0.25-1 $\mu$ m and an n layer 33 in a thickness of 100-2000 Å, all being made of an a-Si film, with a metal electrode 4 being finally formed on the n layer 33 (10 Å = 1 nm.). The p layer 31 is usually made of a boron-doped a-Si film formed from a mixture of $B_2H_6$ and $SiH_4$ gases. Alternatively, in order to provide a wider inhibition band, the layer 31 is made of a boron-doped a-SiC:H film, formed from a mixture of $B_2H_6/SiH_4$ gas, with $CH_4$ or $C_2H_2$ gas. The n layer 32 is usually made of a phosphorus-doped a-Si film. Conversion efficiencies of 9-11% are attainable from currently- available solar cells at AM1 (air mass = 1) and 100 W/cm², and active research efforts are being made in order to attain even higher efficiencies. However, the conventional a-Si solar cells have one serious disadvantage, i.e., a drop in output characteristics, as a result of continuous exposure to light.

An example of such deterioration of the output characteristics of a conventional a-Si solar cells is depicted in Figure 4. The tested cell had an initial conversion efficiency of 9% and a structure of the type shown in Figure 3, which comprises the combination of a glass substrate/ITO/B-doped p type a-SiC:H layer (200 Å thick)/i layer (0.5 $\mu$m thick)/P-doped n type a-Si layer (500 Å thick)/A1 electrode. The graph in Figure 4 shows the time-dependent changes in the short-circuit current ($J_{sc}$), fill factor (FF) and conversion efficiency ($\eta$) relative to their respective initial values when the cell was exposed to light for four continuous hours at AM1 and 100 mW/cm². The values of $J_{sc}$ and FF dropped by about 5%, causing a 10% drop in $\eta$. Another solar cell having entirely the same structure as that used in this four-hour test was subjected to an outdoor exposure test. As a result, it was found that the four-hour continuous exposure to light at AM1 mW/cm² corresponds to an outdoor exposure for three days. On the basis of these data, the conversion efficiency of a solar cell subjected to long-term outdoor exposure is estimated to drop by approximately 50% in fifteen years. For most practical applications, solar cells must have a conversion efficiency drop of $\leqq$ 10% in fifteen years, which corresponds to a drop of $\leqq$ 1% for four-hour continuous exposure to light. Actual cell performance, however, falls far short of this requirement and improved stability is absolutely indispensable to future efforts toward the development of commercial solar cells.

## SUMMARY OF THE INVENTION

The principal object, therefore, of the present invention is to provide an a-Si solar cell that achieves an improved conversion efficiency by preventing any drop in the output characteristics under continuous exposure to light, thus eliminating the major problem of conventional solar cell fabricated by deposition of a-Si layers with the aid of glow discharge decomposition techniques.

In accordance with the present invention, the stated object is achieved by incorporating an n-type dopant in the i layer, and this is based on the recognition that the drop in the characteristics of an a-Si solar cell, as a result of continuous exposure to light, is due to a p-type dopant that is autodoped into the growing i layer. If boron is used as a dopant for the formation of a p layer, phosphorous may be used an an n-type dopant to cancel the autodoping effect of the boron. If the i layer is formed in the reaction chamber where the p layer is formed, the effective amount of phosphorous ranges from 1 x $10^{16}$ to 5 x $10^{17}$ atoms per cm³. If the i layer is formed in a reaction chamber separate from the p layer forming chamber, the effective amount ranges from 1 x $10^{15}$ to 5 x $10^{17}$ atoms per cm³.

## BRIEF DESCRIPTION OF THE DRAWINGS

The above and other objects, advantages and features of the present invention will be more fully understood when considered in conjunction with the following drawings, of which:

Figure 1 is a graph showing the initial conversion efficiency of an a-Si solar cell on a glass substrate and the change in conversion efficiency resulting from continuous exposure to light as a function of the doping level of phosphorous incorporated in the i layer in accordance with the present invention;

Figure 2 is a graph showing the time-dependent change in conversion efficiency of an a-Si solar cell on a glass substrate in accordance with one embodiment of the invention;

Figure 3 is a cross-sectional view of a solar cell with a p-i-n structure on a glass substrate incorporating the concept of the present invention;

Figure 4 is a graph showing the time-dependent change in the output characteristics of a conventional solar cell, of the type shown in Figure 1, that occurs as a result of continuous exposure to light;

Figure 5 is a graph showing, like Figure 1, the initial conversion efficiency of a solar cell having three a-Si layers formed on a glass in separate reaction chambers, as well as the change in conversion efficiency resulting from continuous light exposure, as a function of phosporous doping in the i layer in accordance with the present invention;

Figure 6 is a cross-section of an a-Si solar cell with a p-i-n structure on a stainless steel substrate incorporating the concept of the present invention;

Figure 7 is a cross-section of a solar cell having two layers of p-i-n structure stacked on a glass substrate incorporating the concept of the present invention; and

Figure 8 is a cross-section of a solar cell having two layers of p-i-n structure stacked on a stainless steel substrate incorporating the concept of the present invention.

The following reference numerals correspond to the following elements throughout the drawings and the discussion which follows: 1: glass substrate; 2: transparent electrode; 31, 34: p-layer of a-Si film; 32, 35: i-layer of a-Si film; 33, 36: n-layer of a-Si film; 4: metal electrode; 5: stainless steel substrate.

## DETAILED DESCRIPTION OF THE INVENTION

In accordance with the first embodiment of the present invention, there is provided an a-Si solar cell composed of an assembly of a glass substrate/ITO/SnO$_2$ film/p-i-n a-Si layer/ metal electrode. If, in the prior art, p, i and n layers of a-Si film are successively formed within a single reaction chamber, the i layer is autodoped with a p-type dopant, for example, boron, originating from the wall of the reaction chamber or from the substrate support. Given the p-i-n structure shown above, wherein the p layer is made of a boron-doped a-SiC:H layer with a thickness of 150 Å, the i layer of an a-Si layer with a thickness of 0.5 μ m and the n layer of a phosphorous-doped a-Si layer with a thickness of 500 Å, a depth analysis of the i layer reveals a uniform distribution of about 1 x 10$^{17}$ boron atoms per cm$^3$. A solar cell having improved stability against continuous exposure to light can be obtained by incorporating a trace level of phosphorous in the i layer being formed.

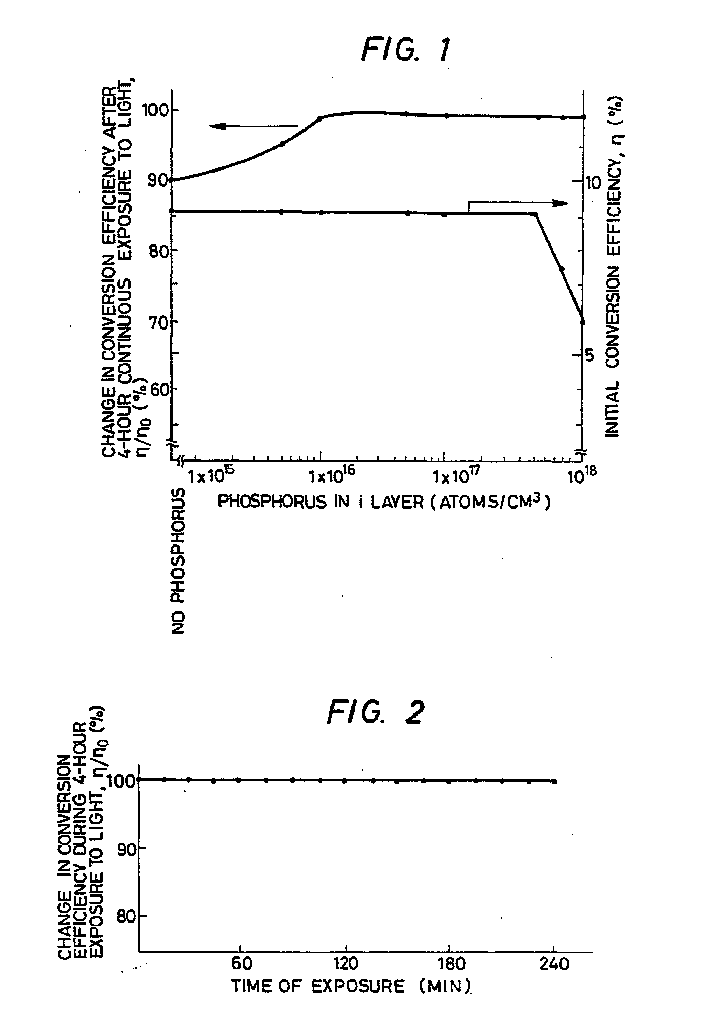

Figure 1 shows the initial conversion efficiency of a solar cell as a function of phosphorous levels in the i layer. Figure 1 also shows the relationship between P levels in the i layer and the change in the solar cell efficiency during a four- hour continuous exposure to light at AM1 and 100 mW/cm$^3$. It is apparent from Figure 1 that the stability of the cell against continuous exposure to light is improved as the doping level of phosphorous is increased, and by adding at least 1 x 10$^{16}$ phosphorous atoms per cm$^3$ of the i layer, the drop in the conversion efficiency of the cell is reduced to 1% or below. On the other hand, the initial characteristics of the cell remain constant so long as the number of phosphorous atoms present in the i layer is not more than 5 x 10$^{17}$/cm$^3$, but if this value is exceeded, there occurs a drop in the conversion efficiency of the cell. With the a-Si solar cell having a p-i-n structure on a glass substrate that is fabricated within a single reaction chamber, as is usually the case, about 10$^{17}$ boron atoms are present per cm$^3$ of the i layer. If such boron atoms are compensated by adding 1 x 10$^{16}$ to 5 x 10$^{17}$ phosphorous atoms per cm$^3$ of the i layer being formed, a solar cell can be obtained that exhibits high initial characteristics, but which will not experience a greater than 1% change in the conversion efficiency during a continuous four-hour light exposure.

Figure 2 shows the time versus conversion efficiency profile of a solar cell that contained 1 x 10$^{17}$ phosphorous atoms per cm$^3$ of the i layer and which was exposed to light for four continuous hours. It is apparent from Figure 2 that the timedependent change in efficiency was negligible.

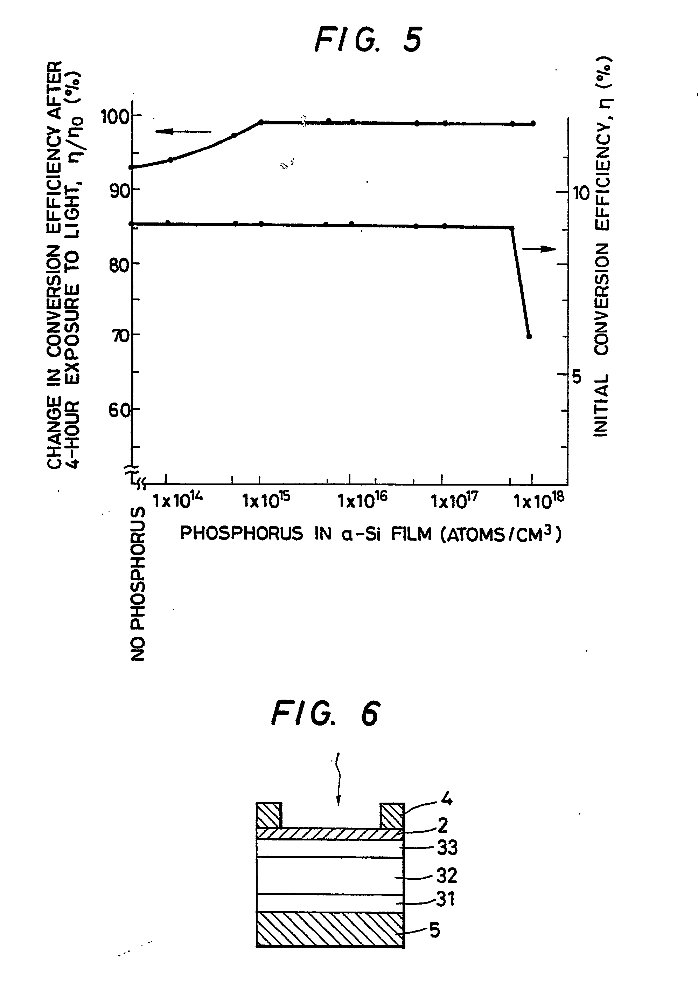

In accordance with the second embodiment of the present invention, there is provided an a-Si solar cell having a p-i-n structure on a glass substrate that is formed by a glow discharge decomposing apparatus, which allows the respective p, i and n layers to be formed in separate reaction chambers. The apparatus consists of five chambers, i.e., a substrate mounting chamber, a p-layer forming chamber, an i-layer forming chamber, an n-layer forming chamber and a delivery chamber. A support carrying the substrate successively passes through each of the chambers for deposition of the respective a-Si layers. The boron level that is autodoped in the i layer being formed is lower than when the three a-Si layers are formed within a single reaction chamber, and the approximate value is 1 x 10$^{16}$ boron atoms per cm$^3$. Figure 5 shows both the initial conversion efficiency and the stability against continuous light exposure of the solar cell of interest as a function of phosphorous level in the i layer. Compared with the case where the p, i and n layers are formed within the same reaction chamber, the optimum level of phosphorous doping in the i layer shifts to the lower side, i.e., the range of 1 x 10$^{15}$ to 5 x 10$^{17}$ atoms/cm$^3$. By incorporating phosphorous atoms in the i layer so that their doping level is within these limits, a solar cell can be obtained that exhibits high initial characteristics, but which will not experience a greater than 1% change in conversion efficiency during a continuous four- hour exposure to light.

In accordance with the third embodiment of the present invention, there is provided an a-Si solar cell having a p-i-n structure on a stainless steel substrate. As shown in Figure 6, this cell consists of a stainless steel substrate 5 on which are deposited successively p layer 31, an i layer 32 and an n layer 33, which is overlaid with a transparent electrode 2 and a topmost metal electrode 4. As in the case of the cell arrangements shown above, using a glass substrate, if the p, i and n layers are formed within a single reaction chamber, about 10$^{17}$ boron atoms are autodoped per cm$^3$ of the i layer, and this value is decreased to about 1 x 10$^{16}$/cm$^3$ if the three a-Si layers are formed in separate reaction chambers. As a result, the conversion efficiency at the end of continuous four-hour exposure to light is decreased by about 10% in the former case and by about 7% in the latter case. Experiments were also conducted to investigate the effects of phosphorous doping of the i layer on the stability of the solar cell, having the construction shown in Figure 6, and the change in its initial conversion efficiency. As a result, it was confirmed that if the three a-Si layers are formed within a single reaction chamber, a solar cell that exhibits high initial characteristics, but which will not experience a more than 1% drop in conversion efficiency during a continuous four-hour light exposure can be obtained by incorporating $1 \times 10^{16}$ to $5 \times 10^{17}$ phosphorous atoms per $cm^3$ of the i layer.

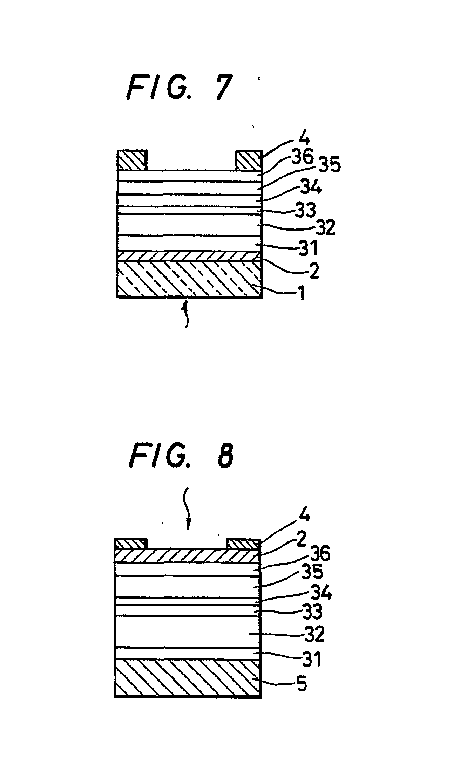

Finally, in accordance with the fourth embodiment of the present invention, a stacked a-Si solar cell is provided wherein a plurality of p-i-n structures are made of an a-Si film in stacked relation on a substrate. Figures 7 and 8 show junction structures having two layers of p-i-n structure. Figure 7 refers to a cell using a glass substrate, whereas Figure 8 shows a cell using a stainless steel substrate. The cell shown in Figure 7 is fabricated by first providing a glass substrate 1 having a vapor-deposited layer of transparent electrode 2, then forming the first stack of p layer 31, i layer 32 and n layer 33, and a second stack of such layers (34, 35 and 36), which is overlaid with a metal electrode 4. In a similar manner, the cell shown in Figure 8 is fabricated by first providing a stainless steel substrate 5, then forming the first stack of p layer 31, i layer 32 and n layer 33, and the second stack of such layers (34, 35 and 36), which is overlaid with metal electrodes 2 and 4.

By properly designing the thicknesses of the individual layers, the stacked-type solar cells shown in Figures 7 and 8 are given the ability to achieve conversion efficiencies comparable to those of the non-stacked type cells having only one layer of p-i-n structure and, at the same time, the open-circuit voltage $V_{OC}$ of the stacked solar cell is twice as high as that of the non-stacked cell. Therefore, the concept of stacking two layers of p-i-n structure is currently used in the solar cells for consumer use, that require high operational voltages, such as cells in hand-held electronic calculators intended for use under fluorescent lamps. Also available today is a tandem a-Si solar cell, wherein three layers of p-i-n structures are stacked with a view to provide a larger photocurrent through efficient use of incident light. In a typical layer arrangement, the i layer in the topmost cell facing the light source is made of a nitrogen-doped a-Si film having the greatest energy gap, and the bottommost cell is made of a germanium-doped a-Si film having the smallest energy gap.

The present inventors investigated not only the stabilizing effects of adding phosphorous to the i layer in stacked a- Si solar cells, but also the change in their initial conversion efficiency, as a function of the phosphorous doping of the i layer. As in the case of the cell using a single layer of p-i-n structure, stacked cells that exhibit high initial characteristics, and yet do not experience a more than 1% change in the conversion efficiency during four-hour continuous exposure to light, can be obtained by incorporating $1 \times 10^{16}$ to $5 \times 10^{17}$ phosphorous atoms per $cm^3$ of the i layer in each of the stacked p-i-n structures if they are formed within a single reaction chamber, and $1 \times 10^{15}$ to $5 \times 10^{17}$ phosphorous atoms per $cm^3$ of the i layer if the stacked p-i-n structures are formed in separate reaction chambers.

Therefore, by incorporating the specified amount of phosphorous in the i layer of the p-i-n structure on a substrate, solar cells can be obtained which have practical stability in performance and which exhibit high initial characteristics, without experiencing a more than 10% drop in conversion efficiency during a fifteen-year use in outdoors.

The applicability of the concept of the present invention is not limited to using boron as a p-type dopant. The invention can also be implemented effectively if the autodoping of other p-type dopants, such as gallium, is compensated by incorporating phosphorous of other n-type dopants, such as arsenic, in the i layer.

In accordance with the present invention, an a-Si solar cell, with the p-i-n structure that exhibits high initial conversion efficiency and whose performance remains highly stable against continuous exposure to light, can be fabricated by incorporating in the i layer a sufficient concentration level of an n-type dopant to compensate for the p-type dopant that is autodoped during the formation of the i layer at one stage of the successive deposition of p, i and n layers of a-Si film on a substrate.

The above-described description and the accompanying drawings are merely illustrative of the application of the principles of the present invention and are not limiting. Numerous other arrangements which embody the principles of the invention may be readily devised by those skilled in the art. Accordingly, the invention is not limited by the foregoing description, but is only limited by the scope of the appended claims.

## Claims

1. A process for producing an amorphous silicon solar cell by forming a p-i-n structure on a substrate by successive deposition of p, i and n layers of amorphous silicon using the glow discharge decomposition method, with the p layer lying closest to the substrate and the n layer lying atop the i layer, characterised by doping the i layer with an n-type dopant to cancel the autodoping effect of the p type dopant.

2. The process according to Claim 1, wherein the p layer is formed using boron as a dopant, while the i layer is doped in a range of $1 \times 10^{16}$ to $5 \times 10^{17}$ phosphorous atoms per $cm^3$, said p layer and said i layer being formed in a same reaction chamber.

3. The process according to Claim 1, wherein the p layer is formed using boron as a dopant, while the i layer is doped in a range of $1 \times 10^{15}$ to $5 \times 10^{17}$ phosphorous atoms per $cm^3$, said p layer and said i layer being formed in separate reaction chambers.

4. The process according to Claim 1, wherein said p layer is formed from a boron-doped a-SiC:H layer with a thickness of approximately 15 nm, said i layer is formed of an a-Si layer with a thickness of approximately 0.5 micrometer, and said n layer is formed of a phosphorous-doped a-Si layer with a thickness of approximately 50 nm.

5. The process according to Claim 1, wherein the substrate is formed of glass.

6. The process according to Claim 1, wherein the substrate is formed of stainless steel.

7. The process according to Claim 1, wherein said p layer is doped with gallium and said i layer is doped with arsenic.

8. Process for producing a stacked amorphous silicon solar cell by forming a plurality of p-i-n structures on a substrate by successive deposition of p, i and n layers of amorphous silicon using the glow disoharge decomposition method, with each p-i-n structure comprising a p layer lying closest to the substrate and an n layer lying atop an i layer, the improvement comprising doping each i layer with an n-type dopant to cancel the autodoping effect of the p type dopant.

9. The process according to Claim 8, wherein each p layer is formed using boron as a dopant, while each i layer is doped in the range of $1 \times 10^{16}$ to $5 \times 10^{17}$ phosphorous atoms per cm³, the p layer and the i layer of each p-i-n structure being formed in the same reaction chamber.

10. The process according to Claim 8, wherein each p layer is formed using boron as a dopant, while each i layer is doped in the range of $1 \times 10^{15}$ to $5 \times 10^{17}$ phosphorous atoms per cm³, the p layer and the i layer of each p-i-n structure being formed in separate reaction chambers.

11. An amorphous silicon solar cell manufactured in accordance with one of the claims 1–7 comprising a p-i-n structure formed on a substrate, with the p layer lying closest to the substrate and the n layer lying atop the i layer, said i layer including an n-type dopant to cancel the autodoping effect of the p type dopant.

12. A solar cell as in Claim 11, wherein said p layer is doped with boron and said i layer is doped with phosphorous in a range of $1 \times 10^{15}$ to $5 \times 10^{17}$ phosphorous atoms per cm³.

13. A solar cell as in Claim 11, wherein said p layer is doped with gallium and said i layer is doped with arsenic.

14. A solar cell as in Claim 11, wherein said substrate is formed of glass.

15. A solar cell as in Claim 11, wherein said substrate is formed of stainless steel.

16. A solar cell as in Claim 11, wherein said p layer is formed from a boron-doped a-SiC:H layer with a thickness of approximately 15 nm, said i layer is formed of an a-Si layer with a thickness of approximately 0.5 micrometer, and said n layer is formed of a phosphorous-doped a-Si layer with a thickness of approximately 50 nm.

17. A stacked amorphous silicon solar cell manufactured in accordance with one of the claims 8–10 comprising a plurality of p-i-n structures formed on a substrate, with each p-i-n structure comprising a p layer lying closest to the substrate and an n layer lying atop an i layer, each said i layer including an n-type dopant to cancel the autodoping effect of the p type dopant.

18. A solar cell as in Claim 17, wherein each said p layer is doped with boron and each said i layer is doped with phosphorous in a range of $1 \times 10^{15}$ to $5 \times 10^{17}$ phosphorous atoms per cm³.

19. A solar cell as in Claim 17, wherein each said p layer is doped with gallium and each said i layer is doped with arsenic.

20. A solar cell as in Claim 17, wherein said substrate is formed of glass.

21. A solar cell as in Claim 17, wherein said substrate is formed of stainless steel.

**Patentansprüche**

1. Verfahren zur Herstellung einer Solarzelle auf der Basis von amorphem Silizium durch Ausbilden einer p-i-n-Struktur auf einem Substrat durch aufeinanderfolgendes Aufbringen einer p-, i- und einer n-Schicht aus amorphem Silizium unter Anwendung des Glühentladungszerlegungsverfahrens, wobei die p-Schicht dem Substrat am nächsten liegt und die n-Schicht oben auf der i-Schicht angeordnet ist, gekennzeichnet durch Dotieren der i-Schicht mit einem Dotierungsmittel vom n-Typ, um den Selbstdotierungseffekt des Dotierungsmittels vom p-Typ aufzuheben.

2. Verfahren nach Anspruch 1, wobei die p-Schicht unter Verwendung von Bor als Dotierungsmittel gebildet wird, während die i-Schicht in einem Bereich von $1 \times 10^{16}$ bis $5 \times 10^{17}$ Phosphoratomen pro Kubikzentimeter dotiert wird, und die p-Schicht und die i-Schicht in der selben Reaktionskammer gebildet werden.

3. Verfahren nach Anspruch 1, wobei die p-Schicht unter Verwendung von Bor als Dotierungsmittel gebildet wird, während die i-Schicht in einem Bereich von $1 \times 10^{15}$ bis zu $5 \times 10^{17}$ Phosphoratomen pro Kubikzentimeter dotiert wird und die p-Schicht und die i-Schicht in getrennten Reaktionskammern hergestellt werden.

4. Verfahren nach Anspruch 1, wobei die p-Schicht aus einer mit Bor dotierten a-SiC:H-Schicht mit einer Dicke von ungefähr 15 Nanometern gebildet wird, die i-Schicht aus einer a-Si-Schicht mit einer Dicke von ungefähr 0,5 Mikrometern, und die n-Schicht aus einer mit Phosphor dotierten a-Si-Schicht mit einer Dicke von ungefähr 50 Nanometern gebildet wird.

5. Verfahren nach Anspruch 1, wobei das Substrat aus Glas gebildet wird.

6. Verfahren nach Anspruch 1, wobei das Substrat aus rostfreiem Stahl gebildet wird.

7. Verfahren nach Anspruch 1, wobei die p-Schicht mit Gallium und die i-Schicht mit Arsen dotiert wird.

8. Verfahren zur Herstellung einer geschichteten Solarzelle aus amorphem Silizium durch Bilden einer Vielzahl von p-i-n-Strukturen auf einem Substrat durch aufeinanderfolgendes Aufbringen einer p-, i- und n-Schicht aus amorphem Silizium, unter Anwendung des Glühentladungszerlegungsverfahrens, wobei jede p-i-n-Schicht, die dem Substrat am nächsten liegt, und eine n-Schicht, die oben auf der i-Schicht liegt, umfaßt, wobei die Verbesserung darin besteht, jede i-Schicht mit einem Dotierungsmittel vom n-Typ zu dotieren, um den Selbstdotierungseffekt des p-Typ-Dotierungsmittels aufzuheben.

9. Verfahren nach Anspruch 8, wobei jede p-Schicht durch Verwendung von Bor als Dotierungsmittel gebildet wird, während jede i-Schicht in einem Bereich von $1 \times 10^{16}$ bis $5 \times 10^{17}$ Phosphoratomen pro Kubikzentimeter dotiert wird, und die p-Schicht und die i-Schicht von jeder p-i-n-Struktur in der selben Reaktionskammer erzeugt werden.

10. Verfahren nach Anspruch 8, wobei jede p-Schicht unter Verwendung von Bor als Dotierungsmittel gebildet wird, während jede i-Schicht in einem Bereich von $1 \times 10^{15}$ bis $5 \times 10^{17}$ Phosphoratomen pro Kubikzentimeter dotiert wird, und die p-Schicht und die i-Schicht von jeder p-i-n-Struktur in getrennten Reaktionskammern erzeugt werden.

11. Eine Solarzelle auf der Basis von amorphem Silizium, hergestellt entsprechend einem der Ansprüche 1 bis 7, mit einer p-i-n-Struktur, die auf einem Substrat gebildet ist, wobei die p-Schicht dem Substrat am nächsten liegt und die n-Schicht oben auf der i-Schicht liegt, und die i-Schicht ein Dotierungsmittel vom n-Typ enthält, um den Selbstdotierungseffekt des p-Typ-Dotierungsmittels aufzuheben.

12. Eine Solarzelle nach Anspruch 11, wobei die p-Schicht mit Bor dotiert ist und die i-Schicht mit Phosphor in einem Bereich von $1 \times 10^{15}$ bis $5 \times 10^{17}$ Phosphoratomen pro Kubikzentimeter dotiert ist.

13. Solarzelle nach Anspruch 11, wobei die p-Schicht mit Gallium und die i-Schicht mit Arsen dotiert ist.

14. Eine Solarzelle nach Anspruch 11, wobei das Substrat aus Glas gebildet ist.

15. Eine Solarzelle nach Anspruch 11, wobei das Substrat aus rostfreiem Stahl gebildet ist.

16. Eine Solarzelle nach Anspruch 11, wobei die p-Schicht aus einer mit Bor dotierten a-SiC:H-Schicht mit einer Dicke von ungefähr 15 Nanometern gebildet ist, die i-Schicht von einer a-Si-Schicht mit einer Dicke von ungefähr 0,5 Mikrometern gebildet ist und die n-Schicht aus einer mit Phosphor dotierten a-Si-Schicht mit einer Dicke von ungefähr 50 Nanometern gebildet ist.

17. Eine geschichtete Solarzelle auf der Basis von amorphem Silizium, hergestellt entsprechend einem der Ansprüche 8 bis 10, mit einer Vielzahl von auf einem Substrat gebildeten p-i-n-Strukturen, wobei jede p-i-n-Struktur eine p-Schicht, die am nächsten zum Substrat angeordnet ist und eine n-Schicht, die über der i-Schicht liegt, enthält, wobei jede i-Schicht ein Dotierungsmittel vom n-Typ enthält, um den Selbstdotierungseffekt der p-Typ-Dotierung auszuschalten.

18. Solarzelle nach Anspruch 17, worin jede p-Schicht mit Bor dotiert und jede i-Schicht mit Phosphor in einem Bereich von $1 \times 10^{15}$ bis $5 \times 10^{17}$ Phosphoratomen pro Kubikzentimeter dotiert ist.

19. Solarzelle nach Anspruch 17, worin jede p-Schicht mit Gallium und jede i-Schicht mit Arsen dotiert ist.

20. Eine Solarzelle nach Anspruch 17, worin das Substrat aus Glas gebildet ist.

21. Eine Solarzelle nach Anspruch 17, worin das Substrat aus rostfreiem Stahl gebildet ist.

## Revendications

1. Procédé de fabrication d'une cellule solaire au silicium amorphe par formation d'une structure p-i-n sur un substrat par dépôt successif de couches p, i et n de silicium amorphe à l'aide du procédé de décomposition par décharge luminescente, la couche p étant la plus proche du substrat et la couche n étant située sur la couche i, caractérisé en ce que la couche i est dopée par un dopant de type n pour annuler l'effet autodopant du dopant de type p.

2. Procédé selon la revendication 1, dans lequel la couche p est formée en utilisant le bore comme dopant, tandis que la couche i est dopée selon une gamme de $1 \times 10^{16}$ à $5 \times 10^{17}$ atomes de phosphore par cm³, ladite couche p et ladite couche i étant formées dans la même chambre de réaction.

3. Procédé selon la revendication 1, dans lequel la couche p est formée en utilisant le bore comme dopant, tandis que la couche i est dopée selon une gamme de $1 \times 10^{15}$ à $5 \times 10^{17}$ atomes de phosphore par cm³, ladite couche p et ladite couche i étant formées dans des chambres de réaction séparées.

4. Procédé selon la revendication 1, dans lequel ladite couche p est formée à partir d'une couche de a-SiC : H dopée au bore ayant une épaisseur d'approximativement 15 nm, ladite couche i est formée d'une couche de a-Si ayant une épaisseur d'approximativement 0,5 μm et ladite couche n est formée d'une couche de a-Si dopée au phosphore ayant une épaisseur d'approximativement 50 nm.

5. Procédé selon la revendication 1, dans lequel le substrat est formé de verre.

6. Procédé selon la revendication 1, dans lequel le substrat est formé d'acier inoxydable.

7. Procédé selon la revendication 1, dans lequel ladite couche p est dopée par du gallium et ladite couche i est dopée par de l'arsenic.

8. Procédé de fabrication d'une cellule solaire au silicium amorphe à empilement par formation d'une pluralité de structures p-i-n sur un substrat par dépôt successif de couches p, i et n de silicium amorphe à l'aide du procédé de décomposition par décharge luminescente, chaque structure p-i-n comprenant une couche p à proximité du substrat et une couche n située sur une couche i, le perfectionnement comprenant le dopage de chaque couche i par un dopant de type n pour annuler l'effet autodopant du dopant de type p.

9. Procédé selon la revendication 8, dans lequel chaque couche p est formée en utilisant le bore comme dopant, tandis que chaque couche i est dopée dans la gamme de $1 \times 10^{16}$ à $5 \times 10^{17}$ atomes de phosphore par cm³, la couche p et la couche i de chaque structure p-i-n étant formées dans la même chambre de réaction.

10. Procédé selon la revendication 8, dans lequel chaque couche p est formée en utilisant le bore comme dopant, tandis que chaque couche i est dopée dans la gamme de $1 \times 10^{15}$ à $5 \times 10^{17}$ atomes de phosphore par cm³, la couche p et la couche i de chaque structure p-i-n étant formées dans des chambres de réaction séparées.

11. Cellule solaire au silicium amorphe fabriquée selon l'une des revendications 1 à 7, comprenant une structure p-i-n formée sur un substrat, la couche p étant à proximité du substrat et la couche n se trouvant sur la couche i, ladite couche i comprenant un dopant de type n pour annuler l'effet autodopant du dopant de type p.

12. Cellule solaire selon la revendication 11, dans laquelle ladite couche p est dopée par le bore et ladite couche i est dopée par le phosphore dans une gamme de $1 \times 10^{15}$ à $5 \times 10^{17}$ atomes de phosphore par $cm^3$.

13. Cellule solaire selon la revendication 11, dans laquelle ladite couche p est dopée par le gallium et ladite couche i est dopée par l'arsenic.

14. Cellule solaire selon la revendication 11, dans laquelle ledit substrat est formé de verre.

15. Cellule solaire selon la revendication 11, dans laquelle ledit substrat est formé d'acier inoxydable.

16. Cellule solaire selon la revendication 11, dans laquelle ladite couche p est constituée par une couche de a-SiC : H dopée par le bore ayant une épaisseur d'approximativement 15 nm, ladite couche i est formée d'une couche de a-Si ayant une épaisseur d'approximativement 0,5 µm et ladite couche n est formée d'une couche de a-Si dopée par le phosphore ayant une épaisseur d'approximativement 50 nm.

17. Cellule solaire au silicium amorphe à empilement fabriquée selon l'une des revendications 8 à 10, comprenant une pluralité de structures p-i-n formées sur un substrat, chaque structure p-i-n comprenant une couche p proche du substrat et une couche n disposée sur une couche i, chaque couche i comprenant un dopant de type n pour annuler l'effet autodopant du dopant de type p.

18. Cellule solaire selon la revendication 17, dans laquelle chaque couche p est dopée par le bore et chaque couche i est dopée par le phosphore dans une gamme de $1 \times 10^{15}$ à $5 \times 10^{17}$ atomes de phosphore par $cm^3$.

19. Cellule solaire selon la revendication 17, dans laquelle chaque couche p est dopée par le gallium et chaque couche i est dopée par l'arsenic.

20. Cellule solaire selon la revendication 17, dans laquelle ledit substrat est formé de verre.

21. Cellule solaire selon la revendication 17, dans laquelle ledit substrat est formé d'acier inoxydable.

## FIG. 1

## FIG. 2

# FIG. 3

# FIG. 4

## FIG. 5

## FIG. 6

FIG. 7

FIG. 8